(19) Europäisches Patentamt
European Patent Office
Office européen des brevets

(11) **EP 2 360 483 B1**

(12) **EUROPÄISCHE PATENTSCHRIFT**

(45) Veröffentlichungstag und Bekanntmachung des Hinweises auf die Patenterteilung:
**01.04.2015 Patentblatt 2015/14**

(21) Anmeldenummer: **11150113.6**

(22) Anmeldetag: **04.01.2011**

(51) Int Cl.:
*G01R 19/00* (2006.01)     *H02M 7/5387* (2007.01)
*G01R 19/25* (2006.01)     *H02M 7/539* (2006.01)
*H02M 7/5395* (2006.01)     *G01R 31/34* (2006.01)
*H02M 1/00* (2007.01)

(54) **Verfahren und Vorrichtung zur Strommessung in einem mehrphasigen Stromnetz**

Method and device for current measurement in a multi-phase electrical network

Procédé et dispositif de mesure du courant dans un réseau de courant multiphase

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.01.2010 DE 102010001181**

(43) Veröffentlichungstag der Anmeldung:
**24.08.2011 Patentblatt 2011/34**

(73) Patentinhaber: **Robert Bosch GmbH**
**70442 Stuttgart (DE)**

(72) Erfinder:
• **Finke, Sven**
**1103 Budapest (HU)**
• **Kuehn, Timo**
**76307 Karlsbad (DE)**
• **Kurfiss, Jochen**
**75417 Lomersheim (DE)**

(56) Entgegenhaltungen:
EP-A1- 0 648 008          EP-A1- 1 347 567
EP-A2- 1 345 312          WO-A1-96/23347
DE-A1-102004 040 051      DE-A1-102005 062 759
DE-A1-102008 001 025      DE-U1- 20 004 909
DE-U1- 20 301 317         US-A- 4 520 298
US-A- 5 309 349           US-A1- 2003 006 749
US-A1- 2004 056 661       US-B1- 6 181 587

## Beschreibung

Die Erfindung betrifft ein Verfahren zur Strommessung mit einer Messverstärkerschaltung in einem mehrphasigen Stromnetz, bei dem durch jeweils mindestens ein steuerbares Schaltelement einer Phase eine gewünschte Bestromung eines elektrischen Verbrauchers erfolgt, und eine Steuereinheit ein ein die Einschaltdauer des jeweiligen Schaltelements steuerndes Taktmuster aufweisendes Ansteuersignal erzeugt, um die gewünschte Bestromung zu erreichen, wobei Taktmustern der Ansteuersignale Messfenster zur Strommessung, insbesondere zur Messung von Phasenströmen, zugeordnet, sind und Taktmuster zeitlich verschoben werden, um Messfenster ausreichender zeitlicher Größe zu erhalten.

Stand der Technik

Bei Elektromotoren mit mehrphasiger Ansteuerung besteht oft der Wunsch, die Phasenströme zu erfassen. Handelt es sich um eine Bestromung eines Elektromotors mittels einer steuerbaren Brücke, die in ihren einzelnen Brückenzweigen steuerbare Schaltelemente aufweist, so lässt sich der Elektromotor in gewünschter Weise bestromen. Um die Phasenströme zu erfassen, wird in jeder Phasenleitung ein niederohmiger Widerstand (Shunt) angeordnet. Der Aufwand dieser mehrphasigen Messanordnung ist entsprechend groß.

Aus der Offenlegungsschrift DE 10 2008 001 025 A1 ist es weiterhin bekannt, die Messung des Stroms mit nur einem einzigen Shunt durchzuführen. Um dies zu ermöglichen, ist es notwendig, die Taktmuster zeitlich zu verschieben, um Messfenster mit ausreichender zeitlicher Größe zu erhalten, innerhalb derer eine Stromerfassung mittels des Shunts erfolgen kann. Gemäß dem bekannten Verfahren ist vorgesehen, dass, wenn möglich, eine Doppelabtastung zur Erfassung eines zweiten Stromwerts der gleichen Phase durchgeführt wird. Ist die Doppelabtastung nicht möglich, wird ein dem zweiten Stromwert entsprechender Wert von einem Speicher bereitgestellt, was jedoch dazu führt, dass eine Offset-Ripple-Kompensation mit "eingefrorenen" Werten erfolgt. Eine automatische Nachführung der Ripple-Offsets über den gesamten Motor-Winkelbereich ist hierbei nicht möglich.

Ähnliche Verfahren sind aus den Dokumenten DE 10 2005 062759 A1, EP 1 347 567 A1, US 5 309 349 A, US 2004/056661 A1 sowie WO 96/23347 A1 bekannt.

Offenbarung der Erfindung

Erfindungsgemäß ist vorgesehen, dass die Taktmuster der aufsteigenden Einschaltdauer nach sortiert verschoben werden, wobei das Schaltelement mit der kürzesten Einschaltdauer zuerst eingeschaltet wird. Es ist erfindungsgemäß also vorgesehen, dass die Taktmuster einer bestimmten Regel folgend verschoben werden. Das Verschieben erfolgt dabei derart, dass die Taktmuster in Abhängigkeit der Einschaltdauer des anzusteuernden Schaltelements verschoben werden. Die Verschiebung erfolgt dabei sortiert nach der aufsteigenden beziehungsweise zunehmenden Einschaltdauer. Das bedeutet, dass das Taktmuster mit der kürzesten Einschaltdauer zuerst oder auch nicht verschoben wird, sodass das Schaltelement mit der kürzesten Einschaltdauer zuerst eingeschaltet wird. Die Taktmuster mit längeren Einschaltdauern werden entsprechend weiter verschoben, sodass die Schaltelemente mit der jeweils nächst höheren (längeren) Einschaltdauer nacheinander eingeschaltet werden, wodurch sich eine Reihenfolge ergibt, die durch die jeweilige Einschaltdauer vorgegeben wird. Durch dieses vorteilhafte sortierte Verschieben nach der aufsteigenden beziehungsweise zunehmenden Einschaltdauer der Taktmuster wird gewährleistet, dass auch nach dem Ausschalten des jeweiligen Schaltelements ein Messfenster ausreichender zeitlicher Größe zur Verfügung steht, innerhalb dessen mittels des einen Shunts der Strom in der jeweiligen Phase ein zweites Mal gemessen werden kann. Das sortierte Verschieben führt dazu, dass das zuerst eingeschaltete Schaltelement auch zuerst ausgeschaltet, das anschließend eingeschaltete Schaltelement anschließend ausgeschaltet und ein zuletzt eingeschaltetes Schaltelement auch zuletzt wieder ausgeschaltet wird. Hierdurch wird sichergestellt, dass eine Doppelabtastung in jedem Motor-Winkelbereich möglich ist.

Vorteilhafterweise wird bei einem dreiphasigen Stromnetz anschließend das Schaltelement mit der mittleren Einschaltdauer und abschließend das Schaltelement mit der längsten Einschaltdauer eingeschaltet. Hierdurch ist es möglich, die tatsächlichen Ripple-Offsets in jedem Arbeitspunkt zu ermitteln, wodurch eine automatische Nachführung (beziehungsweise Kompensation) der Ripple-Offsets über den gesamten Arbeitsbereich möglich ist. Hierdurch kann die Genauigkeit der Strommessung erhöht werden. Der Vorteil zeigt sich vor allem dann, wenn die Ripple-Offsets nicht konstant sind.

Weiterhin ist vorgesehen, dass die Verschiebungszeit mindestens der Zeit entspricht, die die Messverstärkerschaltung braucht, bis ein eingeschwungener Zustand erreicht ist. Der eingeschwungene Zustand muss erreicht werden, um einen aussagekräftigen Stromwert messen zu können. Somit werden die Taktmuster um mindestens die Einschwing-Zeit entsprechend der oben beschriebenen Reihenfolge verschoben.

Vorteilhafterweise erfolgt in je einem Messfenster die Messung eines Phasenstroms des Verbrauchers. Die Messung der einzelnen Phasenströme erfolgt demgemäß zeitlich nacheinander.

Zweckmäßigerweise wird als Ansteuersignal ein Pulsweitenmodulationssignal erzeugt beziehungsweise genutzt. Die Ansteuerung der steuerbaren Schaltelemente erfolgt demgemäß durch Pulsweitenmodulation (PWM), wobei aufgrund der sortierten Verschiebung der Taktmuster keine symmetrische, sondern eine asymmetrische Pulsweitenmodulation durchgeführt wird.

Zweckmäßigerweise erfolgt die Messung des Phasenstroms in einer Pulsweitenmodulations-Periode zweimal. Dies bedeutet, dass pro Pulsweitenmodulation-Periode eines Taktmusters zwei Messfenster vorgesehen werden, innerhalb derer die Messung des Phasenstroms erfolgt. Durch die oben beschriebene erfindungsgemäße Reihenfolge der verschobenen Taktmuster wird gewährleistet, dass in beiden Messfenstern ausreichend Zeit zur Verfügung steht, dass ein eingeschwungener Zustand an dem Messverstärker vorliegt.

Bevorzugt wird als Verbraucher ein Permanentmagnet-Synchronmotor (PSM) bestromt. Bei Permanentmagnet-Synchronmotoren verändern sich die Spulen-Induktivitäten über den mechanischen Umfang, was zu nicht konstanten Ripple-Offsets führt. Vielmehr sind die Ripple-Offsets drehwinkelabhängig und beeinflussen somit die Genauigkeit der Strommessung. Insbesondere hier zeigt sich der Vorteil des vorteilhaften Verfahrens zur Strommessung, bei dem der Phasenstrom zweimal innerhalb einer Pulsweitenmodulations-Periode gemessen wird und dies über den gesamten Motor-Winkelbereich hinweg möglich ist. Die Offset-Ripples können somit über den gesamten Motor-Winkelbereich erfasst und kompensiert werden. Alternativ wird als Verbraucher eine Asynchronmaschine bestromt.

Weiterhin ist vorgesehen, dass die Bestromung des Verbrauchers mittels einer steuerbaren Brückenschaltung erfolgt, die als Schaltelemente elektronische Bauteile, insbesondere Transistoren und/oder Thyristoren umfasst. Diese Schaltelemente weisen Steuereingänge auf, an die die Ansteuersignale angelegt werden, wodurch die Schaltzustände der Schaltelemente verändert werden. Vorzugsweise werden als Transistoren Feldeffekttransistoren, besonders bevorzugt MOS-FETs, verwendet. Der Verbraucher, insbesondere der genannte Permanentmagnet-Synchronmotor, weist bevorzugt eine Stern-Schaltung auf. Die Schaltelemente befinden sich in den einzelnen Zweigen der Brückenschaltung, wobei insbesondere eine Brückenschaltung mit einer B6-Topologie genutzt wird und der Verbraucher beispielsweise ein dreiphasiger Permanentmagnet-Synchronmotor oder eine Asynchronmaschine ist. Vorteilhafterweise wird die Brückenschaltung von einem Gleichstromkreis, insbesondere einem Gleichstromzwischenkreis, gespeist.

Schließlich ist vorgesehen, dass die Strommessung mittels eines in dem die Brückenschaltung speisenden Gleichstromkreises angeordneten Shunts gemessen wird. Das Signal an dem Shunt wird dann mittels des Messverstärkers verstärkt und bevorzugt mittels eines Analog-Digital-Wandlers umgesetzt, sodass es für verschiedene Zwecke zur Verfügung steht.

Die erfindungsgemäße Vorrichtung zeichnet sich durch ein mehrphasiges Stromnetz aus, das eine Messverstärkerschaltung sowie jeweils mindestens ein steuerbares Schaltelement einer Phase sowie eine Steuereinheit umfasst, wobei die Steuereinheit ein die Einschaltdauer des jeweiligen Schaltelements steuerndes Taktmuster aufweisendes Ansteuersignal erzeugt, um eine gewünschte Bestromung des elektrischen Verbrauchers zu erreichen, und durch eine Einrichtung zum sortierten Verschieben der Taktmuster in Abhängigkeit der Länge ihrer Einschaltdauer.

Im Folgenden soll die Erfindung anhand der Zeichnung näher erläutert werden. Dazu zeigen

Figur 1     eine Vorrichtung zur Strommessung,

Figur 2     Ripple-Offsets über den Motor-Winkelbereich eines Permanent-magnet-Synchronmotors,

Figur 3     sortiert verschobene Taktmuster und

Figur 4     eine Schnittdarstellung eines dreiphasigen Spannungssystems.

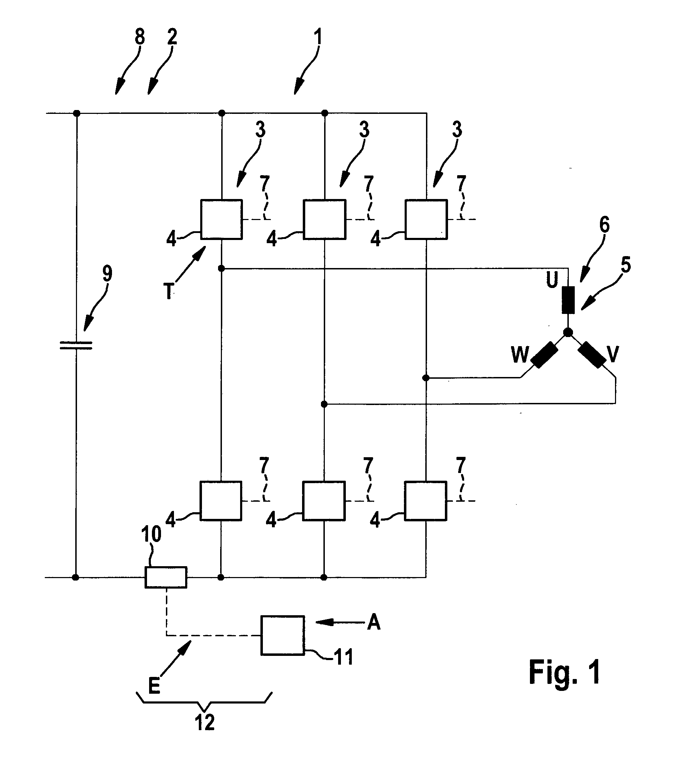

Die Figur 1 zeigt eine Brückenschaltung 1, die an einen Gleichstromkreis 2 angeschlossen ist. Die Brückenschaltung 1 ist als Brückenschaltung mit einer B6-Topologie mit drei Brückenzweigen 3 ausgebildet. Jeder Brückenzweig 3 weist zwei steuerbare Schaltelemente 4 auf. Ein Verbraucher 5, der als dreiphasiger Permanentmagnet-Synchronmotor 6 ausgebildet ist, wird von der Brückenschaltung 1 angesteuert. Eine hier nicht näher dargestellte Steuereinheit erzeugt Ansteuersignale mit bestimmten Taktmustern, wobei die Ansteuersignale Steuereingängen 7 der Schaltelemente 4 zugeführt werden, wodurch diese in den elektrisch leitenden oder elektrisch sperrenden Zustand schaltbar beziehungsweise einschaltbar oder ausschaltbar sind. In dem Gleichstromkreis 2, der als Gleichstromzwischenkreis 8 ausgebildet ist, liegt ein Zwischenkreiskondensator 9. Der Gleichstromkreis 2 ist über einen Shunt 10 mit der Brückenschaltung 1 verbunden. Mit dem einzigen Shunt 10 werden in sequenzieller Folge die Phasenströme des Verbrauchers 5 beziehungsweise des Permanentmagnet-Synchronmotors 6 ermittelt. Bevorzugt werden zwei Phasenströme der insgesamt drei Phasenströme gemessen und der dritte Phasenstrom mittels der Kirchhoffschen Gesetze berechnet. An dem Shunt 10 ist ein Analog-Digital-Wandler 11 einer Messverstärkerschaltung 12 angeschlossen, wobei der Analog-Digital-Wandler 11 das analoge Signal des Shunts 10 in ein digitales Signal zur späteren Verarbeitung umwandelt. Die Messverstärkerschaltung weist im Betrieb eine Einschwingzeit E auf. Der Analog-Digital-Wandler 11 besitzt eine Abtastzeit A und die vorzugsweise als Feldeffekttransistoren (FET) ausgebildeten Schaltelemente 4 besitzen eine Totzeit T.

Im Betrieb des oben beschriebenen mehrphasigen Stromnetzes entstehen sogenannte Offset-Anteile, die sich aus einem Operationsverstärker-Offset, und aus Ripple-Offsets bei Strommessungen ergeben. Diese Offset-Anteile werden im laufenden Betrieb automatisch ermittelt, wobei es bisher nur möglich ist, die sogenannten Ripple-Offsets in einem eingeschränkten Winkelbereich (1/6 des Motor-Winkelbereichs) zu ermitteln und zu kompensieren. Im übrigen Winkelbereich (5/6 des Motor-Winkelbereichs) arbeiten die bekannten Systeme mit festgelegten (adaptiven) Ripple-Offset-Werten.

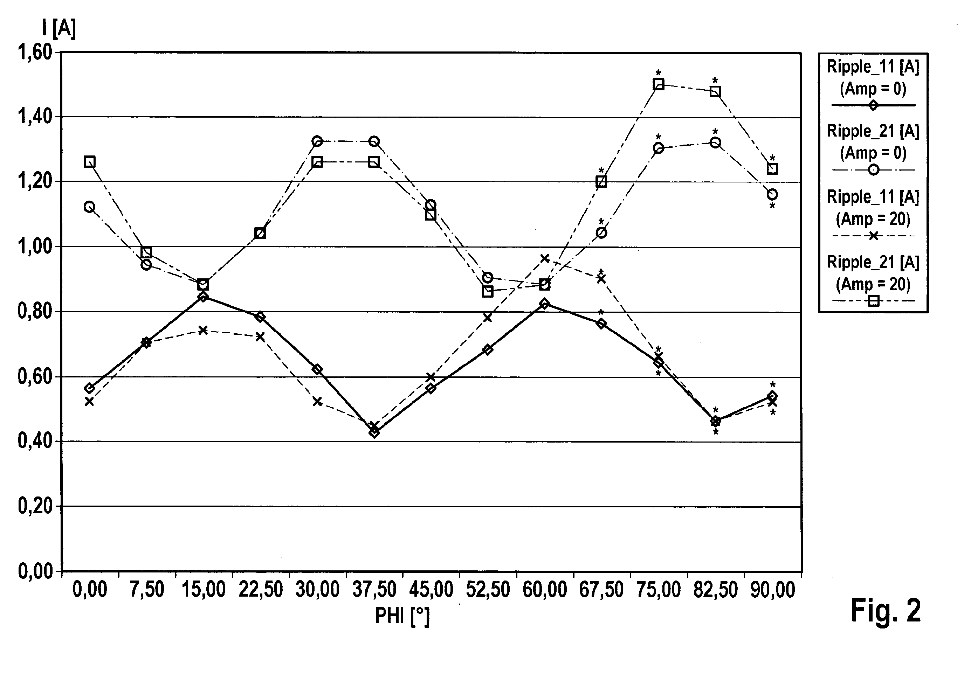

Wie aus der Figur 2 jedoch hervorgeht, variieren die Ripple-Offsets über den Motor-Winkelbereich. So verändern sich bei dem Verbraucher 5 beziehungsweise bei dem Permanentmagnet-Synchronmotor 6 die effektiven Spulen-Induktivitäten über dessen mechanischen Umfang. In der Figur 2 sind hierzu die drehwinkelabhängigen Ripple-Offsets beispielhaft dargestellt, die sich auf die Genauigkeit der Strommessung auswirken. Die Figur 2 zeigt dazu die Ripple-Offsets einer ersten Phase (Ripple_11) und einer zweiten Phase (Ripple_21) über den mechanischen Drehwinkel PHI.

Bisher konnten nur die mit Sternchen markierten Stromwerte in einem ersten Sechstel des Winkelbereichs erfasst werden.

Das vorteilhafte Verfahren zur Strommessung sieht vor, dass die Taktmuster des Ansteuersignals der aufsteigenden Einschaltdauer nach sortiert verschoben werden. Der Phasenversatz beziehungsweise das Verschieben der Taktmuster ist notwendig, um der Messverstärkerschaltung 12 bei der Ein-Shunt-Strommessung die ausreichende Einschwingzeit E zu ermöglichen. Im Folgenden wird dieser Phasenversatz beziehungsweise die Verschiebungszeit als $T_{OP}$ bezeichnet. Die unterschiedlich langen Taktmuster beziehungsweise die Taktmuster mit unterschiedlich langen Einschaltzeiten der Schaltelemente werden also um den genannten Phasenversatz $T_{OP}$ zueinander verschoben sortiert, wobei die Sortierung in Abhängigkeit der Einschaltdauer derart erfolgt, dass zu einem Zeitpunkt T1 zuerst das Schaltelement mit der kürzesten Einschaltdauer eingeschaltet, anschließend, zu einem Zeitpunkt T2, das Schaltelement mit der mittleren Einschaltdauer eingeschaltet und abschließend, zu einem Zeitpunkt T3, das Schaltelement mit der längsten Einschaltdauer eingeschaltet wird. Das anschließende Abschalten der Schaltelemente erfolgt nach den vorgegebenen Pulsweitenmodulations-Zeiten.

Vorteilhafterweise errechnet sich die für eine Strommessung nötige Verschiebung wie folgt: Verschiebung ($T_{OP}$) = Totzeit des Brückenzweigs + Einschwingzeit der Messverstärkerschaltung + Abtastzeit des Digital-Analog-Wandlers.

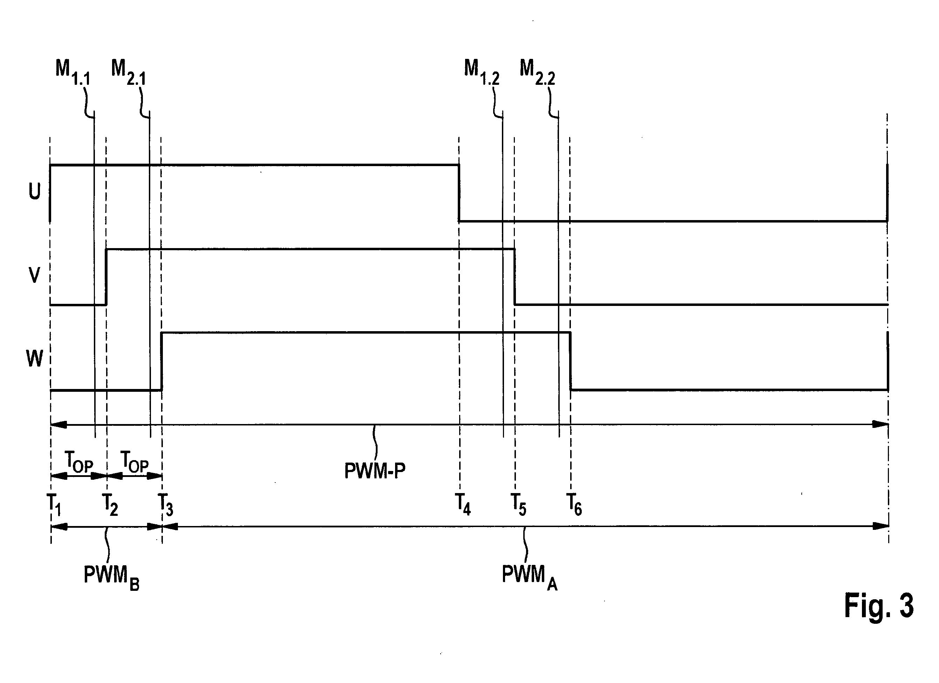

Die Figur 3 zeigt ein entsprechendes Ausführungsbeispiel für entsprechend sortiert verschobene Taktmuster der Phasen U, V und W. Dadurch, dass die Einschaltzeitpunkte um mindestens die Zeitspanne $T_{OP}$ entsprechend sortiert verschoben werden, ist stets gewährleistet, dass nach dem Ausschalten des jeweiligen Schaltelements eine weitere Strommessung und damit eine sogenannte Doppelabtastung durchführbar ist (insgesamt also vier Messungen). Dadurch ist es möglich, die Ripple-Offsets über den gesamten Winkel-Bereich des Verbrauchers 5 zu erfassen und entsprechend zu kompensieren. Die Phasenversetzung beziehungsweise die Zeitspannen $T_{OP}$ bilden somit Messfenster, innerhalb derer die Messung eines Phasenstroms des Verbrauchers 5 erfolgt.

Die beiden Messungen sind mit $M_{1.1}$ und $M_{2.1}$ in der Figur 3 gekennzeichnet. Zum Zeitpunkt der ersten Messung $M_{1.1}$ entspricht der Strom durch den Shunt 10 dem Strom in der Phase U; zum Zeitpunkt der zweiten Messung $M_{2.1}$ entspricht der Strom durch den Shunt 10 dem inversen Strom in der Phase W (dies entspricht der Addition der Phasenströme von U und V). Die Messungen werden in der Teilperiode B ($PWM_B$) der Pulsweitenmodulations-Periode PWM-P durchgeführt. An die Teilperiode B schließt sich die Teilperiode A ($PWM_A$) an, wobei die Summe von Teilperiode B und Teilperiode A die Pulsweitenmodulations-Periode PWM-P ergeben. Während der Teilperiode A erfolgen die zweiten Messungen $M_{1.2}$ und $M_{2.2}$, die den Strom der jeweiligen Phase ein zweites Mal, dieses Mal nach dem Abschalten des jeweiligen Schaltelements erfassen, um eine Doppelabtastung durchzuführen.

Durch das vorteilhafte Verfahren ergeben sich prinzipiell sechs unterschiedliche Arten von PWM-Taktmustern, um zu den Zeitpunkten T1, T2 und T3 von LOW nach HIGH (ein-)zuschalten:

Tabelle 1

| T1 | T2 | T3 |
|----|----|----|
|    |    |    |
| W  | V  | U  |
| W  | U  | V  |
| U  | W  | V  |
| U  | V  | W  |

(fortgesetzt)

| T1 | T2 | T3 |
|----|----|----|
| V | U | W |
| V | W | U |

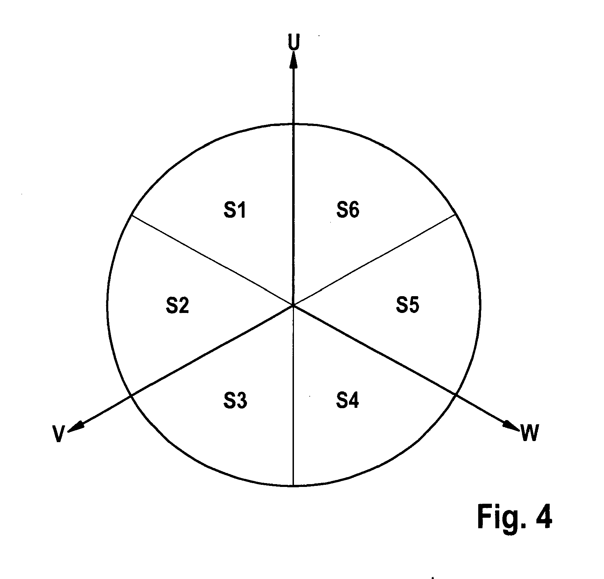

Teilt man das Spannungs-Diagramm in sechs gleiche Sektoren S1, S2, S3, S4, S5 und S6 auf, wie in der Figur 4 dargestellt, so ergeben sich folgende Zusammenhänge für die Spannung U sowie für die Einschaltdauer T_on der Phasen U, V und W:

Tabelle 2

| Sektor: | Bedingung für Spannung U | Bedingung für Einschaltdauer T_on |
|---------|--------------------------|-----------------------------------|
| | | |
| S1 | U_U > U_V > U_W | T_on_U > T_on_V > T_on_W |
| S2 | U_V > U_U > U_W | T_on_V > T_on_U > T_on_W |
| S3 | U_V > U_W > U_U | T_on_V > T_on_W > T_on_U |
| S4 | U_W > U_V > U_U | T_on_W > T_on_V > T_on_U |
| S5 | U_W > U_U > U_V | T_on_W > T_on_U > T_on_V |
| S6 | U_U > U_W > U_V | T_on_U > T_on_W > T_on_V |

Überträgt man nun die Schalt-Vorschrift des oben beschriebenen vorteilhaften Verfahrens zur Strommessung auf die Tabelle 2, so ergibt sich folgendes Schaltverhalten in Bezug auf die Ausschaltreihenfolge zu den Zeitpunkten T4, T5, T6:

Tabelle 3

| Sektor: | T1 | T2 | T3 | T4 | T5 | T6 |
|---------|-----|-----|-----|-----|-----|-----|
| | einschalten | | | ausschalten | | |
| S1 | W | V | U | W | V | U |
| S2 | W | U | V | W | U | V |
| S3 | U | W | V | U | W | V |
| S4 | U | V | W | U | V | W |
| S5 | V | U | W | V | U | W |
| S6 | V | W | U | V | W | U |

Aufgrund der oben stehenden Bedingungen ergibt sich, dass die Zeitspanne zwischen den Zeitpunkten T4 und T5, sowie zwischen den Zeitpunkten T5 und T6 jeweils größer ist als der Phasenversatz $T_{OP}$. Damit ergibt sich insgesamt Folgendes:

T1 < T2 < T3 und T4 < T5 < T6

Da die Zeitspanne $T_{45}$ = T5 - T4 und die Zeitspanne $T_{56}$ = T6 - T5 beide größer als die Zeitspanne $T_{OP}$ sind, ist in allen Sektoren eine ausreichende Zeitdauer vorhanden, um für die beiden gemessenen Ströme jeweils einen weiteren zusätzlichen Messwert mithilfe der 1-Shunt-Strommessung zu ermitteln, sodass insgesamt vier Messwerte erfasst werden können, die zur Ermittlung der Ripple-Offsets und insbesondere zur Kompensation der Ripple-Offsets genutzt werden. Das vorteilhafte Verfahren erlaubt somit eine Doppelabtastung über den gesamten Motor-Winkelbereich des Verbrauchers 5.

In der obigen Ausführung wurden ausschließlich die sechs Sektoren S1 bis S6 betrachtet. Betrachtet man nun zusätzlich noch die Sektor-Grenzen, so gelten in der Tabelle 2 anstelle der Relationszeichen ">" nun die Relationszeichen "≥", sodass sich der Sachverhalt wie folgt verallgemeinern lässt:

$$T_{45} \geq T_{OP} > 0 \text{ und } T_{56} \geq T_{OP} > 0$$

Dies bedeutet, es ist immer, also auch an den Sektor-Grenzen, eine ausreichende Zeitdauer vorhanden, um Doppelmessungen durchführen zu können. Zu welchem benachbarten Sektor die Sektor-Grenze zugeordnet wird, in diesem Verfahren frei wählbar.

Damit das Verfahren in sämtlichen Arbeitspunkten funktioniert, müssen noch folgende Randbedingungen für die PWM-Signale eingehalten werden:

Für die kleinste PWM beziehungsweise die kürzeste Einschaltdauer PWM_MIN muss gelten:

$$PWM\_MIN = (2*T\_OP/PWM\text{-}P) *100\%$$

Für die größte PWM-P beziehungsweise die längste Einschaltdauer PWM_MAX:

$$100\% = (2*T\_OP/PWM\text{-}P) *100\% + PWM\_MAX$$

$$PWM\_MAX = 100\% - (2*T\_OP/PWM\text{-}P) *100\%$$

$$PWM\_MAX = [1 - (2*T\_OP/PWM\text{-}P)] *100\%$$

Insgesamt bedeutet das, dass die PWM-Signale die Anforderung:

$$PWM\_MIN \leq PWM (U, V, W) \leq PWM\_MAX$$

erfüllen müssen.

**Patentansprüche**

1. Verfahren zur Strommessung mit einer Messverstärkerschaltung in einem mehrphasigen Stromnetz, bei dem durch jeweils mindestens ein steuerbares Schaltelement einer Phase eine gewünschte Bestromung eines elektrischen Verbrauches erfolgt, und eine Steuereinheit ein ein die Einschaltdauer des jeweiligen Schaltelements steuerndes Taktmuster aufweisendes Ansteuersignal erzeugt, um die gewünschte Bestromung zu erreichen, wobei Taktmustern der Ansteuersignale Messfenster zur Strommessung, insbesondere zur Messung von Phasenströmen, zugeordnet sind und Taktmuster zeitlich verschoben werden, um Messfenster ausreichender zeitlicher Größe zu erhalten, **dadurch gekennzeichnet, dass** die Taktmuster der aufsteigenden Einschaltdauer nach sortiert verschoben werden, wobei das Schaltelement mit der kürzesten Einschaltdauer zuerst eingeschaltet wird.

2. Verfahren nach Anspruch 1, **dadurch gekennzeichnet, dass** bei einem dreiphasigen Stromnetz anschließend das Schaltelement mit der mittleren Einschaltdauer und abschließend das Schaltelement mit der längsten Einschaltdauer eingeschaltet wird.

3. Verfahren nach einem der vorhergehenden Ansprüche, **dadurch gekennzeichnet, dass** die Verschiebungszeit mindestens der Zeit entspricht, die die Messverstärkerschaltung braucht, bis ein eingeschwungener Zustand erreicht ist.

4. Verfahren nach einem der vorhergehenden Ansprüche, **dadurch gekennzeichnet, dass** in je einem Messfenster die Messung eines Phasenstromes des Verbrauchers erfolgt.

5. Verfahren nach einem der vorhergehenden Ansprüche, **dadurch gekennzeichnet, dass** als Ansteuersignal ein Pulsweitenmodulationssignal erzeugt wird.

**6.** Verfahren nach einem der vorhergehenden Ansprüche, **dadurch gekennzeichnet, dass** die Messung des Phasenstroms in einer Pulsweitenmodulations-Periode zweimal durchgeführt wird.

**7.** Verfahren nach einem der vorhergehenden Ansprüche, **dadurch gekennzeichnet, dass** als Verbraucher ein Permanentmagnet-Synchronmotor oder eine Asynchronmaschine bestromt werden.

**8.** Verfahren nach einem der vorhergehenden Ansprüche, **dadurch gekennzeichnet, dass** die Bestromung des Verbrauchers mittels einer steuerbaren Brückenschaltung, die als Schaltelemente elektronische Bauteile, insbesondere Transistoren und/oder Thyristoren umfasst, erfolgt.

**9.** Verfahren nach einem der vorhergehenden Ansprüche, **dadurch gekennzeichnet, dass** die Strommessung mittels eines in einem die Brückenschaltung speisenden Gleichstromkreises angeordneten Shunts gemessen wird.

**10.** Vorrichtung zur Strommessung, mit einem mehrphasigen Stromnetz, das eine Messverstärkerschaltung sowie jeweils mindestens ein steuerbares Schaltelement einer Phase sowie eine Steuereinheit umfasst, wobei die Steuereinheit ein die Einschaltdauer des jeweiligen Schaltelements steuerndes Taktmuster aufweisendes Ansteuersignal erzeugt, um eine gewünschte Bestromung eines elektrischen Verbrauchers zu erreichen, wobei Taktmustern der Ansteuersignale Messfenster zur Strommessung, insbesondere zur Messung von Phasenströmen, zugeordnet sind und Taktmuster zeitlich verschoben werden, um Messfenster ausreichender zeitlicher Größe zu erhalten, gekennzeichnet durch eine Einrichtung, die Taktmuster der aufsteigenden Einschaltdauer nach sortiert verschiebt, wobei das Schaltelement mit der kürzesten Einschaltdauer zuerst eingeschaltet wird.

**Claims**

**1.** Method for current measurement using an instrument amplifier circuit in a polyphase electrical grid, in which desired energization of an electrical consumer is performed by means of in each case at least one controllable switching element in a phase, and a control unit generates an actuation signal having a clock pattern which controls the switch-on duration of the respective switching element in order to achieve the desired energization, wherein measurement windows for current measurement, in particular for measurement of phase currents, are assigned to clock patterns of the actuation signals, and clock patterns are temporally shifted in order to obtain measurement windows with a sufficient time variable, **characterized in that** the clock patterns, sorted according to increasing switch-on duration, are shifted, wherein the switching element with the shortest switch-on duration is switched on first.

**2.** Method according to Claim 1, **characterized in that**, in the case of a three-phase electrical grid, the switching element with the medium switch-on duration is then switched on and finally the switching element with the longest switch-on duration is switched on.

**3.** Method according to one of the preceding claims, **characterized in that** the shift time at least corresponds to the time which the instrument amplifier circuit needs until a settled state is reached.

**4.** Method according to one of the preceding claims, **characterized in that** the measurement of a phase current of the consumer is performed in in each case one measurement window.

**5.** Method according to one of the preceding claims, **characterized in that** a pulse width modulation signal is generated as actuation signal.

**6.** Method according to one of the preceding claims, **characterized in that** the measurement of the phase current is performed twice in one pulse width modulation period.

**7.** Method according to one of the preceding claims, **characterized in that** a permanent magnet synchronous motor or an asynchronous machine is energized as consumer.

**8.** Method according to one of the preceding claims, **characterized in that** the energization of the consumer is performed by means of a controllable bridge circuit, which comprises, as switching elements, electronic component parts, in particular transistors and/or thyristors.

**9.** Method according to one of the preceding claims, **characterized in that** the current measurement is performed by means of a shunt arranged in a DC circuit feeding the bridge circuit.

10. Apparatus for current measurement, comprising a polyphase electrical grid, which comprises an instrument amplifier circuit and in each case at least one controllable switching element in a phase and a control unit, wherein the control unit generates an actuation signal having a clock pattern which controls the switch-on duration of the respective switching element in order to achieve desired energization of an electrical consumer, wherein measurement windows for current measurement, in particular for measurement of phase currents, are assigned to clock patterns of the actuation signals, and clock patterns are temporally shifted in order to obtain measurement windows with a sufficient time variable, **characterized by** a device which shifts the clock patterns, sorted according to increasing switch-on duration, wherein the switching element with the shortest switch-on duration is switched on first.

## Revendications

1. Procédé de mesure du courant à l'aide d'un circuit d'amplificateur de mesure dans un réseau de courant polyphasé, dans lequel une alimentation en courant souhaitée d'un consommateur électrique s'effectue par chaque fois au moins un élément de commutation asservi à chaque phase, une unité de commande formant un signal de commande qui présente un motif d'horloge qui commande la durée de branchement de l'élément de commutation concerné pour obtenir l'alimentation en énergie souhaitée, des motifs d'horloge des signaux de commande étant associés à des fenêtres de mesure de courant, en particulier de mesure des courants de phase, et les motifs d'horloge étant décalés temporellement pour obtenir des fenêtres de mesure de durée suffisante, **caractérisé en ce que** les motifs d'horloge des durées de branchement croissantes sont pas déplacés sans être triés, l'élément de commutation qui présente la durée de branchement la plus courte étant branché en premier lieu.

2. Procédé selon la revendication 1, **caractérisé en ce que** dans le cas d'un réseau de courant triphasé, l'élément de commutation qui présente la durée de branchement moyenne est branché en premier, l'élément de commutation présentant la durée de branchement la plus longue étant branché en dernier lieu.

3. Procédé selon l'une des revendications précédentes, **caractérisé en ce que** l'instant du décalage correspond au moins à la durée nécessaire pour que le circuit d'amplificateur de mesure ait atteint un état stabilisé.

4. Procédé selon l'une des revendications précédentes, **caractérisé en ce que** la mesure de chaque courant de phase a lieu dans une fenêtre de mesure respective.

5. Procédé selon l'une des revendications précédentes, **caractérisé en ce que** le signal de commande formé est un signal de modulation de largeur d'impulsions.

6. Procédé selon l'une des revendications précédentes, **caractérisé en ce que** la mesure du courant de phase est exécutée deux fois au cours d'une période de modulation de la largeur d'impulsions.

7. Procédé selon l'une des revendications précédentes, **caractérisé en ce que** les consommateurs alimentés en courant sont un moteur synchrone à aimant permanent ou une machine asynchrone.

8. Procédé selon l'une des revendications précédentes, **caractérisé en ce que** l'alimentation en courant du consommateur s'effectue au moyen d'un circuit en pont qui comporte comme éléments de commutation des composants électroniques et en particulier des transistors et/ou des thyristors.

9. Procédé selon l'une des revendications précédentes, **caractérisé en ce que** la mesure du courant s'effectue au moyen d'un pont disposé dans un circuit à courant continu alimentant le circuit en pont.

10. Dispositif de mesure de courant dans un réseau polyphasé d'alimentation en courant qui comporte un circuit d'amplificateur de mesure ainsi qu'au moins un élément de commutation asservi d'une phase, ainsi qu'une unité de commande, l'unité de commande formant un signal de commande qui présente un motif d'horloge qui commande la durée de branchement de l'élément de commutation concerné pour obtenir une alimentation souhaitée en courant d'un consommateur électrique, des motifs d'horloge des signaux de commande étant associés à des fenêtres de mesure de courant, en particulier de mesure de courants de phase, les motifs d'horloge étant décalés temporellement pour obtenir des fenêtres de mesure de taille suffisamment grande, **caractérisé par** un ensemble qui décale les motifs d'horloge des durées de branchement croissantes sans les trier, l'élément de commutation présentant la durée de branchement la plus courte étant branché en premier.

Fig. 1

Fig. 2

EP 2 360 483 B1

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008001025 A1
- DE 102005062759 A1
- EP 1347567 A1
- US 5309349 A
- US 2004056661 A1
- WO 9623347 A1